# EUROPEAN PATENT APPLICATION

(11) **EP 4 761 483 A1**
(43) Date of publication of application: **17.06.2026**
(21) Application number: 24218591.6
(22) Date of filing: 10.12.2024
(51) Int. Cl.: H05K 7/20, G06F 1/20, H01L 23/473

(54) **APPARATUS FOR LIQUID COOLING AT LEAST ONE DATA PROCESSING UNIT, ELECTRONIC DEVICE AND VEHICLE COMPRISING SUCH APPARATUS**

(71) Applicant: Alps Alpine Co., Ltd., Ota-ku, Tokyo 145-8501 (JP)
(72) Inventor: Surugiu, Florin, Gothenburg (SE)
(74) Representative: Schmitt-Nilson Schraud Waibel Wohlfrom Patentanwälte Partnerschaft mbB

(57) **Abstract**

An aspect of the present invention relates to an apparatus (10) for liquid cooling at least one data processing unit (102), comprising: an inlet (12) for receiving a cooling liquid; an outlet (14) for outputting the cooling liquid; an internal cavity (16) arranged between the inlet (12) and the outlet (14) and fluidically connecting the inlet (12) and the outlet (14); at least one heat-conducting plate (18) extending along a side of the internal cavity (16) and comprising a heat-conducting material and configured to be in thermal contact with the at least one data processing unit (102); and a plurality of discrete heat-conducting objects (20) each comprising a heat-conducting material and arranged in the internal cavity (16) in a pattern; wherein each of the plurality of heat-conducting objects (20) contacts at least another one of the plurality of heat-conducting objects (20) in the internal cavity (16); wherein at least one of the plurality of heat-conducting objects (20) is in thermal contact with the at least one heat-conducting plate (18); and wherein the plurality of heat-conducting objects (20) are arranged in the internal cavity (16) such that, when the apparatus (10) is in a liquid cooling operation, the cooling liquid at least partially surrounds the heat-conducting objects (20). Further aspects relate to an electronic device comprising such an apparatus and a vehicle comprising such an electronic device.

## Description

The present invention relates to liquid cooling of at least one data processing unit of an electronic device, such as an electronic control unit (ECU) of a vehicle.

Vehicles include more and more electronic devices, such as an ECU, that comprise one or more data processing units, such as CPUs or GPUs. For a reliable operation of these electronic devices, it is important to prevent excessive heating of the one or more data processing units during operation by efficient cooling.

Conventional cooling apparatuses are, for example, known in the art such as described in JP 2023 011 395, JP 2013 165120 and JP 3 093 727 U.

JP 2023 01 395 describes a heat dissipation member comprising: a plate-shaped base portion that extends in a first direction along the flow direction of a refrigerant and in a second direction orthogonal to the first direction, with a thickness in a third direction orthogonal to both the first and second directions; at least one group of fins, composed of multiple pin fins that protrude in a columnar shape from the base portion toward one side in the third direction. The surface area of the pin fins, which is contactable by the refrigerant, is defined as the surface area of the pin fins. The surface are of the pin fins that is arranged in at least one region is greater than the surface area of the pin fins arranged in another region.

JP 2013 165 120 describes a cooling member having spindle-shaped fins with one end and the other end in the longitudinal direction, wherein the width of the central part in the longitudinal direction is greater than the width at other parts, and the cross-sectional shape parallel to the longitudinal direction is approximately spindle-shaped. A plurality of such fins are erected in a single row on the surface of a heat-generating element in a direction perpendicular to the longitudinal direction.

JP 3 093 727 U describes a heat-dissipating structure comprising a heat-absorbing base and one or more hollow heat-dissipating pillars provided on the upper surface of the heat-absorbing base so that the heat energy generated by the heat-generating element can be rapidly conducted to the upper part of the heat-dissipating pillar, and the heat dissipation can be performed quickly.

Therefore, it is an object of the present invention to provide an improved apparatus for liquid cooling at least one data processing unit, an electronic device comprising such an apparatus and a vehicle comprising such an electronic device.

The present disclosure relates to an apparatus for liquid cooling at least one data processing unit, an electronic device comprising such an apparatus and a vehicle comprising such an electronic device according to the appended claims. Embodiments are disclosed in the respective dependent claims.

According to an aspect of the present invention an apparatus for liquid cooling at least one data processing unit is provided. The apparatus comprises: an inlet for receiving a cooling liquid; an outlet for outputting the cooling liquid; an internal cavity arranged between the inlet and the outlet and fluidically connecting the inlet and the outlet; at least one heat-conducting plate extending along a side of the internal cavity and comprising a heat-conducting material and configured to be in thermal contact with the at least one data processing unit; and a plurality of discrete heat-conducting objects each comprising a heat-conducting material and arranged in the internal cavity in a pattern; wherein each of the plurality of heat-conducting objects contacts at least another one of the plurality of heat-conducting objects in the internal cavity; wherein at least one of the plurality of heat-conducting objects is in thermal contact with the at least one heat-conducting plate; and wherein the plurality of heat-conducting objects are arranged in the internal cavity such that, when the apparatus is in a liquid cooling operation, the cooling liquid at least partially surrounds the heat-conducting objects.

Advantageously, the invention provides a more efficient and compact apparatus for liquid cooling at least one data processing unit, which may comprise or be a CPU and/or a GPU. The invention further provides the advantageous effect that, by arranging the plurality of heat-conducting objects, the thermal mass of the overall heat-conducting body of the apparatus, which transfers heat from the at least one data processing unit to the cooling liquid in a cooling operation of the apparatus and which includes the at least one heat-conducting plate and the plurality heat-conducting objects, may be increased. Additionally, the heat-transferring surface of the heat-conducting body may be increased. Heat from the at least one data processing unit being in thermal contact with the heat-conducting plate may more efficiently be transferred via the heat-conducting plate and the plurality of heat-conducting objects into the cooling liquid. The apparatus according to the invention allows for heat-dissipation to the cooling liquid in all spatial directions. Moreover, the arrangement of the heat-conducting objects causes a turbulent flow, instead of a laminar one, of the cooling liquid that is more efficient and beneficial for cooling. Advantageously, the invention allows for an improved cooling effect and/or performance of the cooling liquid flowing through the apparatus. Furthermore, the apparatus according to the invention may have a simpler and more flexible construction or design. By arranging the plurality of heat-conducting objects, the cooling and/or heat-conducting performance may be adapted to the technical needs.

According to an embodiment, the inlet and the outlet for the cooling liquid are each openings and/or passages arranged at the apparatus. Via the inlet, the cooling liquid may be introduced into the internal cavity. Via the outlet, the cooling liquid may leave the internal cavity. According to an embodiment, the apparatus comprises a housing at which the inlet and outlet are arranged and which includes the internal cavity.

According to an embodiment, the at least one heat-conducting plate is at least a part of a wall and/or cover of the internal cavity. The at least one heat-conducting plate may be a sealing of the internal cavity. The at least one heat-conducting plate may be an integral part of the housing of the apparatus, or a separate element.

Herein, the expression "in thermal contact with" or "in thermal contact to" may include that two components are in direct contact with each other, for example by attaching or mounting one component to the other by using screws or by pressing them against each other, and/or that two components are indirectly in contact, for example via a heat-conducting glue, paste, resin or other heat-conducting elements between the two components, so that heat from one of the components to the other can be transferred.

For example, the at least one data processing unit may be attached to the at least one heat-conducting plate by thermal interface material (TIM), particularly a heat-conducting glue.

Herein, the term "discrete" shall designate objects which are individual and/or independent objects which are separated in an unassembled state of the apparatus. The discrete objects are objects that are not integrally formed with each other and the at least one heat-conducting plate.

In an embodiment, each of the heat-conducting objects contacting the at least one heat-conducting plate contacts at least one other heat-conducting object of the plurality of heat-conducting objects.

In an embodiment, the cooling liquid surrounds at least a part of heat-conducting objects of the plurality of heat-conducting objects in the cooling operation of the apparatus. The cooling liquid may surround each or all of the heat-conducting objects of the plurality of heat-conducting objects. In the cooling operation of the apparatus, the cooling liquid may surround the heat-conducting objects almost completely except in the areas of contact of the heat-conducting objects.

The "areas of contact" may be the areas where the heat-conducting objects contact each other and/or the at least one heat-conducting plate. In the area of contact, at least a part of or each one of the plurality of heat-conducting objects may be provided with a thermal interface material (TIM). This may further increase thermal transfer from one heat-conducting object to another, or from the respective heat-conducting objects to the at least one heat-conducting plate.

Herein, the term "cooling operation" includes the operational state of the apparatus in which the inlet may be connected to a cooling liquid source and the outlet may be connected to a cooling liquid drain such that, on activation of a cooling liquid flow, the cooling liquid flows via the inlet into the internal cavity to the outlet. While flowing around the heat-conducting objects, the cooling liquid may absorb heat from the at least one data processing unit via the at least one heat-conducting plate and the heat-conducting objects.

According to an aspect, the plurality of heat-conducting objects are arranged in a pattern. For example, this may include that the plurality of heat-conducting objects are precisely positioned in the internal cavity to control the flow rate of the cooling liquid and flow properties, such as back pressure, turbulence, etc.

According to an embodiment, at least a part of the plurality of heat-conducting objects is arranged in at least one layer or lattice pattern. In case of a lattice pattern, at least a part of the heat-conducting objects may be located at respective a site or node of the lattice. A number of the heat-conducting objects or all heat-conducting objects may each be located at a site or node of the lattice. The heat-conducting objects of the at least one layer pattern may be arranged in a part of a lattice pattern. Accordingly, the apparatus may have a particularly compact design with enhanced cooling performance.

According to an embodiment, at least a part of the heat-conducting objects are convex objects. Each of the heat-conducting objects may be a convex object. Accordingly, the heat-transfer surface of the heat-conducting objects may be increased to enhance heat-transfer from the heat-conducting objects to the cooling liquid and, thus, enhance cooling performance.

In a further embodiment, at least a part of the heat-conducting objects are spheres and/or polygonal shaped elements. For example, at least a part of the heat-conducting objects are spheres and/or polyhedrons. Each heat-conducting object of the plurality of heat-conducting objects may be a sphere or polyhedron. These shapes are particularly beneficial with regards to the heat transfer to the cooling liquid and, thus, to the cooling performance as a larger number of heat-conducting objects can be arranged in the internal cavity, thereby increasing the thermal mass and the heat dissipation further.

According to an embodiment, at least a part of the heat-conducting objects are deformed and/or compressed spheres and/or polyhedrons. When assembling the apparatus, the at least one heat-conducting plate may be pressed against the heat-conducting objects such that at least a part of the heat-conducting objects are squished together and are thereby deformed and/or compressed in their contacting areas. Each of the plurality of heat-conducting objects may be a deformed and/or compressed sphere or polyhedron. By deforming and/or compressing the heat-conducting objects, the heat-transfer surface between the heat-conducting objects can be increased. Depending on the shape of each of the heat-conducting objects, the compression and/or deformation of the heat-conducting objects may vary at equal thermal transfer. For example, polyhedrons may require a smaller compression and/or deformation than spheres for a similar heat transfer.

According to an embodiment, the heat-conducting objects, in particular at least a part or all, have an average diameter in a range from about 1 mm to about 10 mm. More particularly, the heat-conducting objects, in particular at least a part or all, have an average diameter in a range from about 1 mm to about 3 mm. Accordingly, the heat-conducting objects have an optimized surface area-to-volume ratio. This size range can provide a balance where the surface area is sufficient for efficient heat transfer without excessive bulk. Diameters above 10 mm are also possible, depending on the technical requirements.

According to an embodiment, the heat-conducting material of the plurality of heat-conducting objects and/or of the at least one heat-conducting plate comprises or is at least one of copper, aluminium, silver, boron arsenide and a heat-conducting polymer or any combination thereof.

Copper has one of the highest thermal conductivities among commercially available metals (-398 W/mK at room temperature, i.e. around 20° C), making it excellent for heat transfer in the context of the present invention. Copper is mechanically strong, allowing it to withstand stress and maintain its shape under thermal cycling, making it suitable for high-performance applications. Its malleability allows for precise shaping into intricate designs, such as heat spheres and polyhedrons as described herein, enhancing thermal performance. In order to reduce or prevent corrosion, copper may additionally be treated by pre-oxidation to form a protective layer, protective coating, e.g. nickel coating, or surface passivation.

Aluminium has a lower thermal conductivity than copper (-237 W/mK at room temperature), but it is still highly effective and sufficient for heat dissipation applications in the context of the present invention. Aluminium is significantly lighter than copper (density -2.7 g/cm³ compared to copper's -8.96 g/cm³), making it ideal for applications where weight is a critical factor, such as in vehicles. Aluminium is generally less expensive than copper, resulting in lower production costs of the apparatus. Aluminium is easier to machine and fabricate into complex shapes than copper, reducing manufacturing costs and time. Aluminium is highly recyclable and has a lower environmental footprint during extraction and recycling compared to copper.

Silver has a high thermal conductivity at room temperature as well. Its thermal conductivity lies around 429 W/mK. Boron arsenide has an even higher thermal conductivity which is in the range from about 1000 to 1300 W/mK.

According to an embodiment, the plurality of heat-conducting objects are arranged in multiple layers, wherein at least one of the layers is in thermal contact with the at least one heat-conducting plate and the at least one of the layers being in thermal contact with the at least one heat-conducting plate contacts another layer of the multiple layers. By arranging the plurality of heat-conducting objects in layers, a compact design with enhanced heat dissipation capability can be achieved.

According to an embodiment, at least some of the heat-conducting objects, in particular each or all, of the plurality of heat-conducting objects have two, three, four, five, six, eight or twelve nearest-neighbouring heat-conducting objects or a combination thereof.

Herein, nearest neighbours are those objects which mutually have the smallest spatial distance to each other or are mutually closest to each other in the bulk of objects.

The configuration with twelve nearest-neighbouring heat-conducting objects is particularly advantageous as, in this configuration, a large number of heat-conducting objects can be arranged in the internal cavity of the apparatus.

According to an embodiment, the at least one heat-conducting plate comprises two heat-conducting plates, wherein the two heat-conducting plates are arranged opposite to each other with respect to the internal cavity and each of the two heat-conducting plates is configured to be in thermal contact with at least one respective data processing unit. Thus, it is beneficial that a double-chip set-up can be cooled with only one apparatus. The apparatus can be used in small spaces and data processing units can be arranged flexibly.

According to an embodiment, the apparatus further comprises at least one supporting bar arranged at the inlet and/or the outlet to prevent at least some of the heat-conducting objects of the plurality of heat-conducting objects from misaligning in the internal cavity and/or from moving out of the internal cavity. The at least one supporting bar may be an integral part of the housing of the apparatus.

According to an embodiment, the apparatus further comprises at least one supporting recess configured to receive at least one of the heat-conducting objects of the plurality of heat-conducting objects, the at least one supporting recess being arranged inside the internal cavity. During assembly of the apparatus, the at least one supporting recess helps to align the plurality of heat-conducting objects, simplifying the arrangement of the plurality of heat-conducting objects and the manufacture of the apparatus. Moreover, the at least one supporting recess contributes to preventing the heat-conducting object or objects that are received by the at least one supporting recess from moving out of the internal cavity.

The at least one supporting recess may be formed in the housing of the apparatus. The at least one supporting recess may comprise multiple supporting recesses that may have egg box shape. The at least one heat-conducting plate may also comprise at least one supporting recess configured to receive at least one of the plurality of heat-conducting objects and to hold the at least one of the plurality of heat-conducting objects in place. The at least one supporting recess may be arranged at a side of the at least one heat-conducting plate facing the internal cavity.

According to an embodiment, the apparatus comprises at least one supporting pin arranged inside the internal cavity and configured for aligning at least one heat-conducting object of the plurality of heat-conducting objects. Additionally, the at least one supporting pin is configured to prevent at least some of the plurality of heat-conducting objects from moving out of the internal cavity. During assembly of the apparatus, the at least one supporting pin may help to align the plurality of heat-conducting objects and preventing them from moving out of the internal cavity, simplifying the arrangement of the plurality of heat-conducting objects and the manufacture of the apparatus.

The at least one supporting pin may have cylindrical shape. The at least one supporting pin may be formed at the housing of the apparatus. At least one of the plurality of heat-conducting objects may comprise a through-hole, wherein the inner shape of the through-hole matches the outer circumference of the at least one supporting pin. The at least one supporting pin may be an integral part of the housing of the apparatus.

The at least one heat-conducting plate may comprise at least one supporting pin. The at least one supporting pin may be arranged at a side of the at least one heat-conducting plate facing the internal cavity. The at least one-heat-conducting plate may have at least one receiving recess conforming to the outer shape of the at least one supporting pin and configured to receive at least part of the at least one supporting pin.

In an embodiment, the apparatus is configured to be used in an electronic control unit (ECU) of a vehicle. It is advantageous that the apparatus has a compact size so that an efficient cooling of the electronic control unit can be achieved with lower mechanical energy for the flow of the cooling liquid.

The cooling liquid may comprise or be water. It may comprise or be any suitable coolant or a combination of different coolants.

In another aspect, the internal cavity may be a pocket inside the apparatus in which the plurality of heat-conducting objects can be added in multiple layers and custom positions. The height of layers may be bigger as the height of the pocket by few millimeters. One of the at least one heat-conducting plate may be placed on top of the plurality of heat-conducting objects and pressed against them, therefore forcing the heat-conducting objects to slightly deform and create a bigger contact surface between the heat-conducting objects and between the heat-conducting objects and the housing of the apparatus. The increased contact surface may translate into a larger thermal mass through which the cooling liquid can flow. The cooling liquid can flow through gaps between the heat-conducting objects.

In another aspect, the housing of the apparatus and one of the at least one heat-conducting plate, in particular a bottom heat-conducting plate, may be pre-assembled. A 0.5 to 0.75 mm gap may be left to later force the heat-conducting objects to deform. Then, the plurality of heat-conducting objects may be added into the pocket. After that, another one of the at least one heat-conducting plate, in particular a top heat-conducting plate, is added. Then, a hydraulic press may squish all the parts together. The height of the heat-conducting object layers may initially be bigger as the height of the pocket inside the apparatus. Thus, the plurality of heat-conducting objects may be deformed and squished against each other and against the housing of the apparatus.

According to another aspect of the present invention, an electronic device is provided. The electronic device comprises: at least one data processing unit; and an apparatus according to the invention as described herein. The at least one data processing unit is in thermal contact with the at least one heat-conducting plate.

All features, embodiments, advantages and further explanations provided above with respect to the apparatus apply to the electronic device accordingly.

According to an embodiment, the at least one data processing unit comprises a first data processing unit and a second data processing unit, and the at least one heat-conducting plate comprises a first heat-conducting plate and a second heat-conducting plate. The first data processing unit is in thermal contact with the first heat-conducting plate and the second data processing unit is in thermal contact with the second heat-conducting plate. The first and second heat-conducting plates are arranged opposite to each other with respect to the internal cavity.

Thus, two data processing units may efficiently be cooled in a compact design with one device. The device can be used in applications or situations where only a limited space is available, such as in a vehicle.

The first and second data processing units may each be attached to the respective heat-conducting plate. The first and second heat-conducting plates may be arranged substantially in parallel to each other.

According to an embodiment, the electronic device is part of, comprises or is an electronic control unit (ECU) of a vehicle.

An ECU of a vehicle may generally refer to a control unit that may be configured to manage vehicle functions, such as engine performance, fuel injection, ignition timing, and emissions to ensure optimal efficiency and compliance with regulations. It may be configured to control gear shifting in automatic transmissions for smooth and efficient operation. It may be configured to control Anti-Lock Braking Systems (ABS) and electronic stability control for improved safety. It may manage electrical systems like lighting, wipers, windows, and door locks. It may be configured to activate airbags and seatbelt pretensioners during a collision. Furthermore, the ECU may be configured to manage vehicle connectivity, GPS navigation, and emergency communication systems, and/or entertainment/audio systems. The ECU may be configured to control the self-driving capabilities and/or features and surroundings detection using systems, such as LIDAR, cameras or other sensors.

In an embodiment, one or more data processing units comprise or are a CPU (central processing unit) and/or a GPU (graphical processing unit).

According to yet another aspect of the present invention, a vehicle comprises an electronic device as described herein.

All features, embodiments, advantages and further explanations described herein with respect to the apparatus and the electronic device apply to the vehicle accordingly.

In an embodiment, the vehicle is a smart car. A smart car may generally refer to a technologically advanced vehicle designed to enhance efficiency, safety, and convenience through features like connectivity, advanced driver-assistance systems (ADAS), and eco-friendly powertrains. It may refer to any car with intelligent systems like Al-powered navigation, autonomous driving capabilities, and real-time diagnostics. A smart car often integrates with smartphones and the internet, offering remote access, personalized settings, and over-the-air updates.

In the following, aspects of the invention will be described with reference to the drawings. Aspects shown in the drawings may be combined to form further aspects.
Fig. 1 shows different views of an apparatus for liquid cooling at least one data processing unit according to aspects and embodiments of the invention;
Fig. 2 shows a perspective view of an apparatus for liquid cooling at least one data processing unit according to an embodiment;
Fig. 3 shows different views of an apparatus for liquid cooling at least one data processing unit according to an embodiment;
Fig. 4 shows components of an apparatus for liquid cooling at least one data processing unit according to an embodiment;
Fig. 5 shows different views of an apparatus for liquid cooling at least one data processing unit according to an embodiment;
Fig. 6 shows different lattice arrangements of heat-conducting objects according to embodiments;
Fig. 7 shows different lattice arrangements of heat-conducting objects according to embodiments;
Fig. 8 shows different lattice arrangements of heat-conducting objects according to embodiments;
Fig. 9 shows different lattice arrangements of heat-conducting objects according to embodiments;
Fig. 10 shows a depiction of different shapes of heat-conducting objects and flow of cooling liquid according to embodiments;
Fig. 11 shows an electronic device according to embodiments of the invention; and
Fig. 12 shows a vehicle according to an embodiment of the invention.

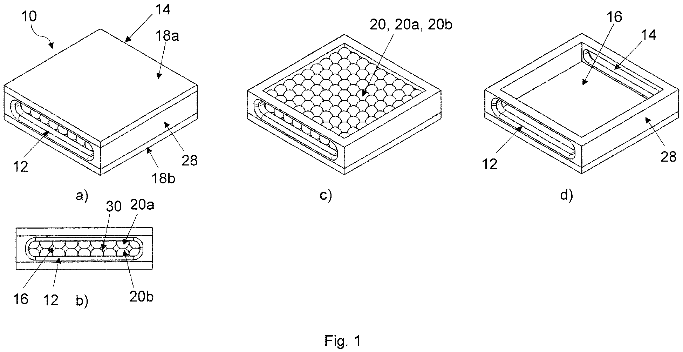

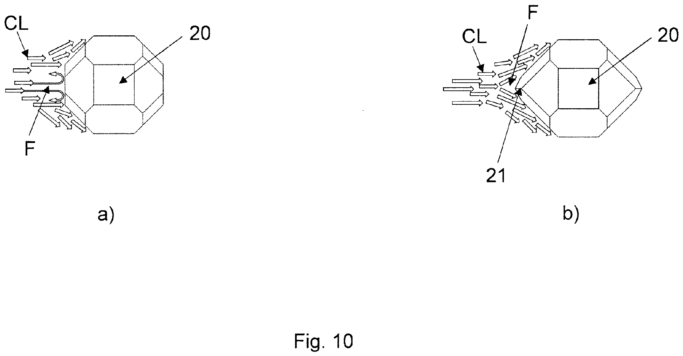

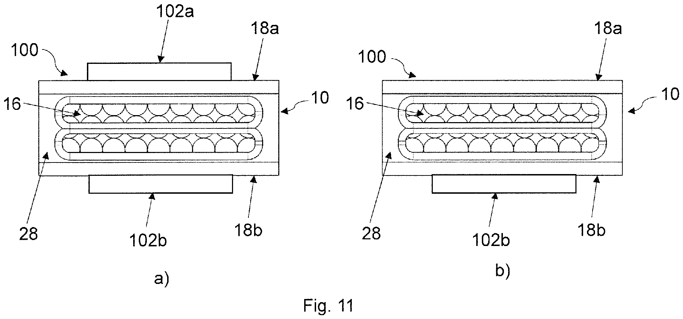

Fig. 1 shows different views of an apparatus for liquid cooling at least one data processing unit according to aspects of the invention. Fig. 1a) shows a perspective view of an apparatus 10 for liquid cooling at least one data processing unit 102a, 102b (shown in Fig. 11). The apparatus 10 comprises an inlet 12 for a cooling liquid CL (shown in Fig. 10), an outlet 14 for the cooling liquid CL, an internal cavity 16 arranged between the inlet 12 and the outlet 14 and fluidically connecting the inlet 12 and the outlet 14, at least one heat-conducting plate 18a, 18b extending along a side of the internal cavity 16 and comprising a heat-conducting material and configured to be in thermal contact with the at least one data processing unit 102a, 102b, and a plurality of discrete heat-conducting objects 20 each comprising a heat-conducting material, which may comprise or be copper and/or aluminium, and arranged in the internal cavity 16. Each of the plurality of heat-conducting objects 20 contacts at least another one of the plurality of heat-conducting objects 20 in the internal cavity 16. At least one of the plurality of heat-conducting objects 20 is in thermal contact with the at least one heat-conducting plate 18a, 18b. Moreover, the plurality of heat-conducting objects 20 are arranged in the internal cavity 16 such that, when the apparatus 10 is in a liquid cooling operation, the cooling liquid CL at least partially surrounds the heat-conducting objects 20.

The apparatus may comprise a housing 28. The internal cavity 16 may be arranged inside the housing 28. The housing 28 may be shaped to form the internal cavity 16.

The housing 28 may confine the internal cavity 16. The housing 28 may have cuboid shape. The housing may comprise or be formed from a polymeric material. The housing 28 may comprise a metallic material. The housing 28 may comprise a combination of a polymer and a metal. The housing 28 may comprise or be formed from the same material as the at least one heat-conducting plate 18a, 18b. The housing 28 may include the at least one heat-conducting plate 18a, 18b.

The apparatus 10 may comprise at least one heat-conducting plate, in the present embodiment two heat-conducting plates 18a, 18b. The two heat-conducting plates 18a, 18b may be arranged opposite to each other with respect to the internal cavity 16 and/or with respect to the housing 28. Each of the two heat-conducting plates 18a, 18b may be configured to be in thermal contact with at least one data processing unit 102a ,102b. The two heat-conducting plates 18a, 18b may comprise or be a first, in particular top, heat-conducting plate 18a and a second, in particular bottom, heat-conducting plate 18b. The first and second heat-conducting plates 18a, 18b may be arranged in parallel to each other at the housing 28.

The inlet 12 and the outlet 14 may be arranged at and/or formed in the housing 28. The inlet 12 and the outlet 14 may be arranged at opposite sides of the apparatus 10, in particular opposite front sides of the housing 28.

Generally, the plurality of heat-conducting objects 20 may be arranged in at least one layer or lattice pattern, or layer or lattice arrangement. Herein, the terms "pattern" and "arrangement" are used interchangeably for the respective arrangement of the heat-conducting objects 20. Such at least one layer or lattice pattern may include one or more layers and/or one or more lattices of heat-conducting objects 20 arranged in a pattern. The plurality of heat-conducting objects 20 may be arranged in multiple layers 20a, 20b. A first layer, in particular top layer 20a, may be in thermal contact with the first heat-conducting plate 18a. A second, in particular bottom layer 20b, may be in thermal contact with the second heat-conducting plate 18b, and both the first and the second layers 20a, 20b contact each other, or may have one or more layers of heat-conducting objects 20 in between them. The plurality of heat-conducting objects 20 may have sphere shape

The plurality of heat-conducting objects 20 may be arranged to form parallel and/or intersecting fluid channels 30 through which cooling liquid CL may flow from the inlet 12 to the outlet 14 in a cooling operation of the apparatus 10. The fluid channels 30 may extend from one side, in particular wall, of the housing 28 to the other and/or from the first heat-conducting plate 18a to the second heat-conducting plate 18b. The fluid channels 30 may extend horizontally, diagonally and/or vertically.

Fig. 1b) shows a side view of the apparatus 10 of Fig. 1a) with a view to the inlet 12. The inlet 12 as well as the outlet 14 (not shown) may be an opening in the housing 28 so that the remaining part of the housing 28 around the opening forms a barrier for the plurality of heat-conducting objects 20 not to misalign and/or move out to of the internal cavity 16.

Fig. 1c) is a perspective view of the apparatus 10 of Fig. 1a) with the first or top heat-conducting plate 18a being removed and/or not assembled. A lattice arrangement of the plurality of heat-conducting objects 20, in particular the first or top layer 20a of the heat-conducting objects 20 is observable. Each one of the plurality of heat-conducting objects may be located at a site or node of a certain lattice. The lattice may for example be a cubic lattice. The heat-conducting objects 20 may be above one another and side by side.

Fig. 1d) shows a perspective view of the apparatus 10 of Fig. 1a) with the plurality of heat-conducting objects 20 and the top heat-conducting plate 18a being removed or not yet assembled. The housing 28 with empty internal cavity 16 and the bottom heat-conducting plate 18b are observable.

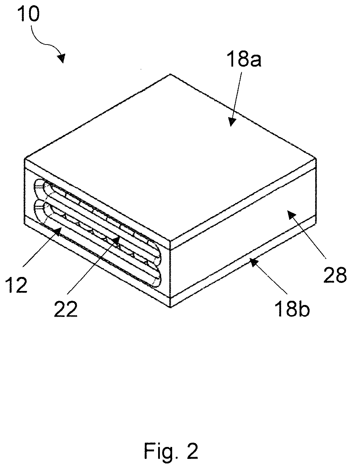

Fig. 2 shows a perspective view of an apparatus 10 for liquid cooling at least one data processing unit according to an embodiment. The apparatus 10 may be designed similarly or identically to the apparatus shown in Fig. 1. The apparatus 10 may additionally comprise a supporting bar 22. A supporting bar 22 may be arranged at the inlet 12 and/or the outlet 14 (not shown). The supporting bar 22 may prevent the heat-conducting objects 20, in particular a middle layer of the heat-conducting objects 20, from misaligning in the internal cavity 16 and/or moving out of the internal cavity 16. The supporting bar 22 may be a horizontal bar or barrier. The supporting bar 22 may be an integral part of the housing 28. The supporting bar 22 may divide the inlet 12 to form a double inlet. The supporting bar 22 may divide the outlet 14 to form a double outlet.

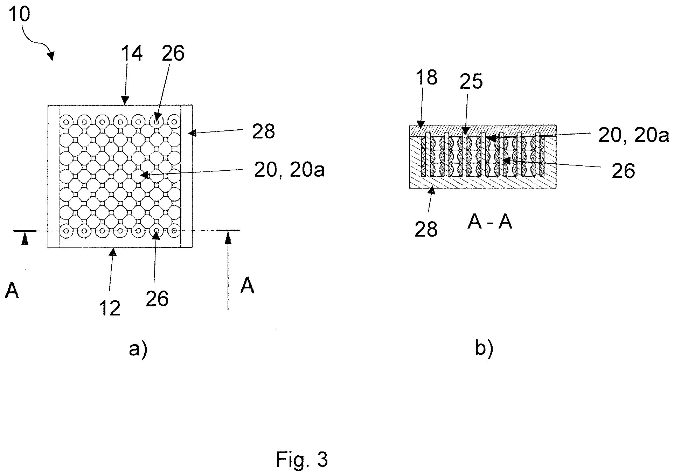

Fig. 3 shows different views of an apparatus 10 for liquid cooling at least one data processing unit according to an embodiment. Fig. 3a) is a top-down view of an apparatus 10 with the top heat-conducting plate 18a being removed or not yet assembled so that the internal cavity 16 and the housing 28 can be observed. The apparatus 10 may have features of the apparatus of Fig. 1. The apparatus 10 may further comprise several supporting pins 26 that are arranged in an edge portion of the internal cavity 16 adjacent to the inlet 12 and the outlet 14. The supporting pins 26 may be integrally formed with the housing 28. The supporting pins may extend from one side, for example the bottom of the housing 28. The supporting pins 26 may be configured for aligning at least some of the heat-conducting objects 20 and prevent them from moving out of the internal cavity 16. For aligning the at least some of the heat-conducting objects 20, the objects may have a through-hole which matches the outer shape, in particular the diameter, of the supporting pins 26. The inner shape of the through-hole may be slightly bigger as the outer shape of the supporting pins 26.

Fig. 3b) shows a cross-section of the apparatus 10 of Fig. 3a) along the line A-A in Fig. 3a). The apparatus may have one top heat-conducting plate 18 covering the internal cavity 16. The supporting pins 26 extend from the bottom of the housing 28 towards the heat-conducting plate 18. The heat-conducting plate 18 may have several receiving recesses 25 configured to receive end portions of the supporting pins 26. The shape of the receiving recesses 25 matches the outer shape of the end portions of the supporting pins 26. This improves rigidity of the apparatus 10 when the heat-conducting plate 18 is assembled.

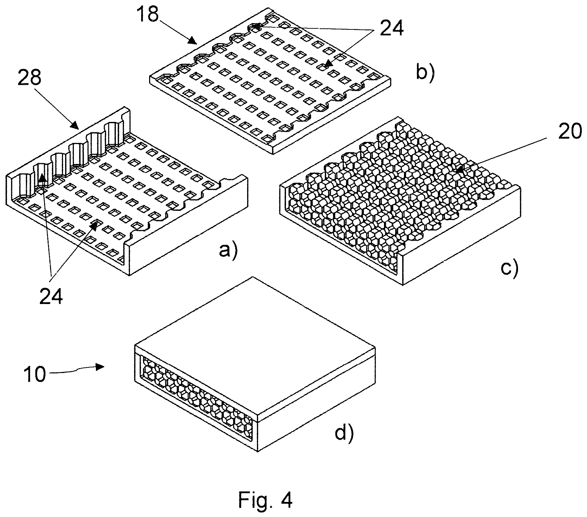

Fig. 4 shows components of an apparatus 10 for liquid cooling at least one data processing unit according to an embodiment. Fig. 4a) is a perspective view of a housing 28. The housing 28 may comprise supporting recesses 24 which may each be configured to receive one heat-conducting object 20 and to prevent it from moving inside or out of the internal cavity 16 and shaped to match the outer shape of the respective heat-conducting object 20. The supporting recesses 24 may be arranged at one or more side walls of the housing 28 and/or at the bottom of the housing 28.

Fig. 4b) shows a perspective view of a heat-conducting plate 18 rotated by 180°, showing a side of the heat-conducting plate facing the internal cavity 16 and/or the heat-conducting objects 20 when the apparatus 10 is assembled. The heat-conducting plate 18 may have several supporting recesses 24. These supporting recesses may have features of the supporting recesses similar or identical to those mentioned with reference to Fig. 4a) and the housing 28.

The housing 28 and the heat-conducting plate 18 may have mating geometrical shape to ensure proper positioning of the heat-conducting objects 20.

Fig. 4c) shows a perspective view of a housing 28 similar to Fig. 4a), wherein polygonal shaped heat-conducting objects 20 or polyhedrons as heat-conducting objects 20 are arranged in the internal cavity 16.

Fig. 4d) shows a perspective view of an assembled apparatus 10 for liquid cooling of at least one data processing unit with polygonal shaped elements or polyhedrons as heat-conducting objects 20 instead of spheres.

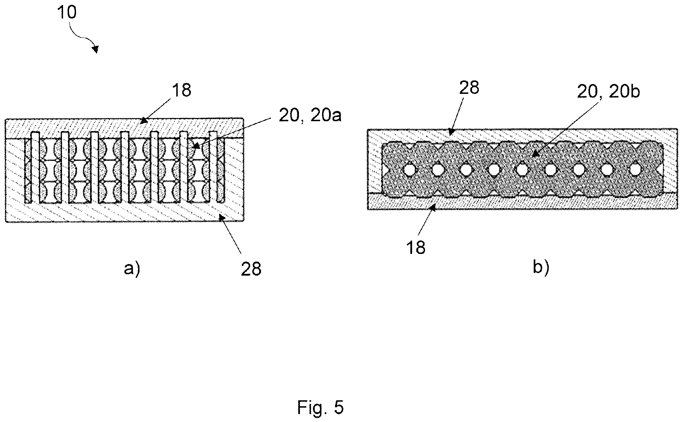

Fig. 5 shows different views of an apparatus 10 for liquid cooling at least one data processing unit according to an embodiment. Fig. 5a) shows a cross-section of an apparatus 10 similar to Fig. 3b). The heat-conducting objects 20 are formed as spheres. The contact surface area between the spheres may be dependent on the deformation caused when mounting a heat-conducting plate 18.

Fig. 5b) shows a cross-section of an apparatus 10 similar to Fig. 4d) along a row of heat-conducting objects 20. The heat-conducting objects 20 are shaped as polygonal shaped elements or polyhedrons. The contact surface area between polygonal elements can be customized and the size can be controlled during design phase. The total contact surface area (contact with all neighboring elements) may be larger compared to sphere design.

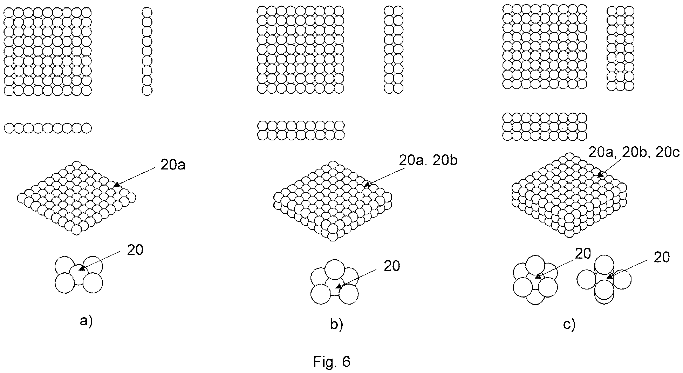

Fig. 6 shows different lattice patterns or arrangements of heat-conducting objects 20 according to various embodiments. Fig. 6a) shows an arrangement of one layer 20a of spherical shaped heat-conducting objects 20 arranged in a square lattice where the maximum interconnections of one object with other objects 20 or the maximum number of nearest-neighbouring objects 20 or the maximum coordination number may be 4.

Fig. 6b) shows an arrangement of two layers 20a, 20b of spherical shaped heat-conducting objects 20 arranged in a square lattice where the maximum interconnections of one object with other objects 20 or the maximum number of nearest-neighbouring objects 20 or the maximum coordination number may be 5.

Fig. 6c) shows an arrangement of three layers 20a, 20b, 20c of spherical shaped heat-conducting objects 20 arranged in a square lattice where the maximum interconnections of one object with other objects 20 or the maximum number of nearest-neighbouring objects 20 or the maximum coordination number may be 6.

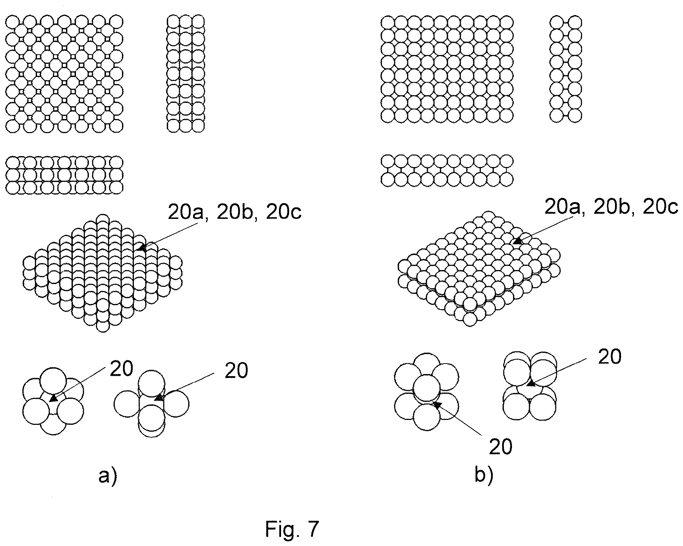

Fig. 7 shows different lattice patterns or arrangements of heat-conducting objects 20 according to various embodiments. Fig. 7a) shows an arrangement of three layers 20a, 20b, 20c of spherical shaped heat-conducting objects 20 arranged in a square lattice where the maximum interconnections of one object with other objects 20 or the maximum number of nearest-neighbouring objects 20 or the maximum coordination number may be 6. Compared to Fig. 6c), adjacent rows of or within one layer may be shifted relative to each other. Adjacent rows of or within one layer may be arranged offset from each other or in a staggered pattern relative to each other.

Fig. 7b) shows an arrangement of three layers 20a, 20b, 20c of spherical shaped heat-conducting objects 20 arranged in a square lattice where the maximum interconnections of one object with other objects 20 or the maximum number of nearest-neighbouring objects 20 or the maximum coordination number may be 8. Adjacent layers may be shifted relative to each other. Adjacent layers may be arranged offset from each other or in a staggered pattern relative to each other. The lattice arrangements or patterns shown in Fig. 7 may provide an increased turbulent flow compared to Fig. 6.

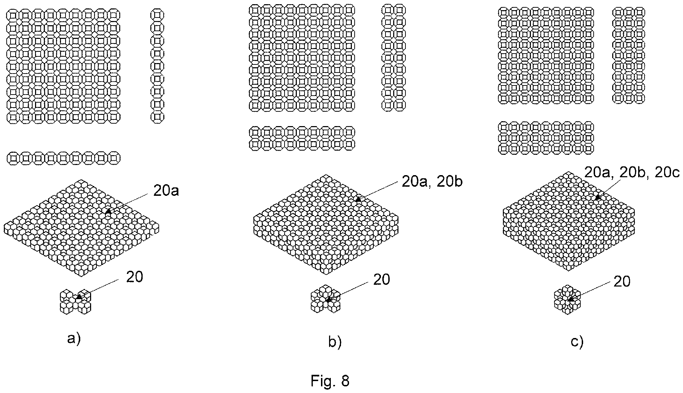

Fig. 8 shows different lattice patterns or arrangements of heat-conducting objects 20 according to various embodiments. Fig. 8a) shows an arrangement of one layer 20a of polygonal shaped heat-conducting objects 20 arranged in a square lattice where the maximum interconnections of one object with other objects 20 or the maximum number of nearest-neighbouring objects 20 or the maximum coordination number may be 4.

Fig. 8b) shows an arrangement of two layers 20a, 20b of polygonal shaped heat-conducting objects 20 arranged in a square lattice where the maximum interconnections of one object with other objects 20 or the maximum number of nearest-neighbouring objects 20 or the maximum coordination number may be 5.

Fig. 8c) shows an arrangement of three layers 20a, 20b, 20c of polygonal shaped heat-conducting objects 20 arranged in a square lattice where the maximum interconnections of one object with other objects 20 or the maximum number of nearest-neighbouring objects 20 or the maximum coordination number may be 6.

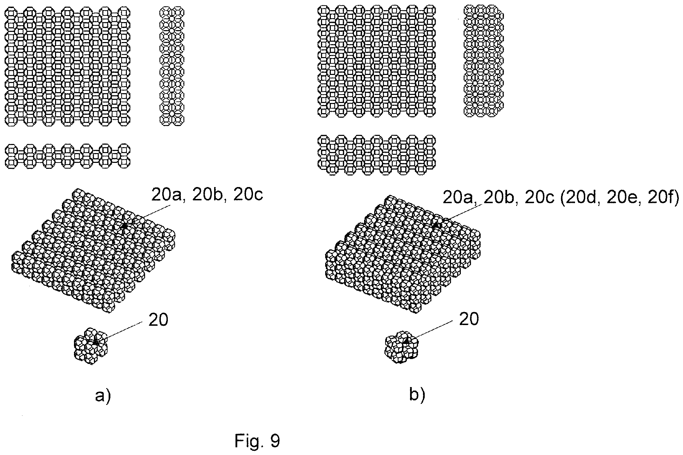

Fig. 9 shows different lattice patterns or arrangements of heat-conducting objects 20 according to various embodiments. Fig. 9a) shows an arrangement of three layers 20a, 20b, 20c of polygonal shaped heat-conducting objects 20 arranged in a square lattice where the maximum interconnections of one object with other objects 20 or the maximum number of nearest-neighbouring objects 20 or the maximum coordination number may be 8. Adjacent layers of heat-conducting objects may be shifted relative to each other. Adjacent layers may be arranged offset from each other or in a staggered pattern relative to each other.

Fig. 9b) shows a pattern of three layers 20a, 20b, 20c with similar or the same height as in Fig. 8c), wherein intermediary layers are added by spacing the heat-conducting objects 20 further apart in horizontal direction. The pitch between vertical columns is bigger in Fig. 9 compared to Fig. 8. The density of heat-conducting objects 20 is increased in Fig. 9b).

From a different viewpoint, Fig. 9b) may show an arrangement of six layers 20a, 20b, 20c, 20d, 20e, 20f of polygonal shaped heat-conducting objects 20 arranged in a square lattice where the maximum interconnections of one object with other objects 20 or the maximum number of nearest-neighbouring objects 20 or the maximum coordination number may be 12. Adjacent layers of heat-conducting objects may be shifted relative to each other. Adjacent layers may be arranged offset from each other or in a staggered pattern relative to each other.

Increasing the number of nearest-neighboring heat-conducting objects provides more heat-conducting paths between the heat-conducting objects 20 (spheres or other polygonal shapes). Polygonal shaped heat-conducting objects may have more and larger contact surfaces with the neighboring objects. However, they may cause a slightly larger pressure drop of the cooling liquid flow since the cooling liquid cannot flow as smooth as through the arrangement of spherical objects. On the other hand, the flow can be more turbulent compared to sphere shape design and this may provide a better cooling performance.

According to an embodiment, at least a part each of the heat-conducting objects 20 comprises an additional thermally conducting layer in at least a part of the outer surface of the respective heat-conducting object 20. The thermally conducting layer may for example comprise or be a thermally conducting glue. When assembling the apparatus 10, at least a part of heat-conducting objects 20 can be brought into contact to each other by the thermally conducting layer. That is, the at least a part of heat-conducting objects can be glued together and arranged at as a whole in the internal cavity 16.

According to an embodiment, at least a part of the heat-conducting objects 20 can be arranged in the internal cavity 16 one by one.

Fig. 10 shows different shapes of heat-conducting objects 20 and flow of cooling liquid CL Fig. 10a) shows the flowing behaviour or flow F of a cooling liquid CL with respect to a polygonal shaped heat-conducting object 20. The object 20 has multiple flat faces and is arranged such that a flowing cooling liquid CL hits one of the flat faces, thereby creating vortices in the flow F or creating a turbulent flow F. This design enhances the creation of a turbulent flow within the internal cavity 16 of the apparatus 10 itself. Having a turbulent flow, the cooling liquid can absorb the heat from the heat-conducting objects 20 more efficiently.

Fig. 10b) shows the flowing behaviour or flow F of a cooling liquid CL with respect to a polygonal shaped heat-conducting object 20 designed differently than in Fig. 10a). The object 20 has multiple flat faces and a ramp portion 21. The object 20 is arranged such that a flowing cooling liquid CL hits the ramp portion 21, which can create a smooth flow F. This design can help to reduce the back pressure. Because of the ramp portion 21, which may be designed as a sharp tip, the cooling liquid CL can flow more smoothly around the object 20. Hence, this design can have a similar pressure drop as a sphere design. However, the cooling performance can be higher as the sphere design because this object 20 can have contact with up to other twelve heat-conducting objects, whereas the spheres can have contact with up to maximum eight neighboring heat-conducting objects.

Fig. 11 shows embodiments of an electronic device 100 according to aspects of the invention. The electronic device 100 may comprise at least one data processing unit 102a and/or 102b and an apparatus 10 as described herein. The at least one data processing unit 102a and/or 102b may be in thermal contact with at least one heat-conducting plate 18a and/or 18b of the apparatus 10. The data processing unit 102a and/or 102b may be a CPU, GPU or other electronic data processing unit, such as an integrated circuit of know kinds.

Fig. 11a) shows an electronic device 100 that may comprise a first data processing unit 102a and a second data processing unit 102b, and a first heat-conducting plate 18a and a second heat-conducting plate 18b. The first data processing unit 102a may be in thermal contact with the first heat-conducting plate 18a and the second data processing unit 102b may be in thermal contact with the second heat-conducting plate 18b. The first and second heat-conducting plates 18a, 18b may be arranged opposite to each other with respect to the housing 28 and/or the internal cavity 16 of the apparatus.

One or each of the first and second data processing units 102a, 102b may be in direct contact with the respective first and second heat-conducting plate 18a, 18b. One or both of the data processing units 102a, 102b may be attached to the respective heat-conducting plates 18a, 18b by means of screws (not shown), or a thermal interface material (TIM), such as a thermally conducting glue or adhesive.

Accordingly, heat and/or thermal energy can be released via two sides. Only one cooling chamber is required. A compact design is possible.

Fig. 11b) shows an electronic device 100 according to an embodiment configured for cooling one data processing unit. The electronic device 100 has one data processing unit 102b that is arranged at the bottom side of the apparatus 10. The data processing unit 102b is arranged at the bottom heat-conducting plate 18b. The plate 18a may be a heat-conducting plate with a similar or the same heat conductivity as the plate 18b at which the data processing unit 102b is arranged or it may be a plate with a lower heat-conductivity than the plate 18b.

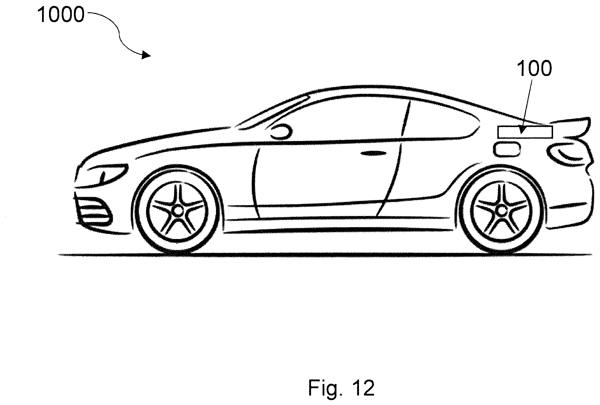

Fig. 12 shows a vehicle 1000 according to aspects of the invention. The vehicle 1000 may be any passenger car, in particular smart car. It comprises an electronic device 100 according to various embodiments as described herein. The electronic device 100 may for example be an electronic control unit (ECU) of the vehicle located at the trunk of the vehicle.

The present invention provides advantages that cooling performance in a compact package can be increased. Two CPU and/or GPU packages can be cooled at the same time. The flow of cooling liquid can be turbulent which provides a high Reyn-olds number. Thus, heat transfer may be increased. The apparatus may have an increased power efficiency. The water flow may be kept low, resulting in a longer lifetime of water pumps and low operating noises. Furthermore, the apparatus can withstand high compressing forces due to the internal structure and arrangement of heat-conducting objects.

In particular, a water pump, e.g. provided in the vehicle, will consume less power and will run quieter because the surface area of the heatsink can be increased, depending on thermal requirement, and because the water flow inside the heatsink is turbulent. The multitude of contact surfaces between the heat-conducting objects can provide a large thermal mass which will ensure a stable cooling temperature, which is beneficial especially in vehicle applications with limited space and cooling power capabilities.

In particular, aspects of the invention provide an improved way of shaping a heatsink internal structure in a three-dimensional way. As compared to a fin or pin-shaped heatsink design, as described in the known prior art mentioned herein in the introductory part, in which flow of cooling liquid is taking place essentially only in two-dimensional directions (i.e. provide a laminar flow), a heatsink design with the heat-conducting objects as proposed with the present invention forces the cooling liquid to flow in a three-dimensional space that translates into a three-dimensional turbulent flow, i.e. in a horizontal and vertical plane. Such three-dimensional turbulent flow is very beneficial for increasing the heat transfer from the heatsink to the cooling liquid. Particularly the convex body shape and the position of the objects is also a beneficial factor which provides flexibility depending on the use case. In addition to this, the new heatsink design provides a better heat dissipation in multiple directions through the contact areas between the heat-conducting objects and between the heat-conducting objects and the heatsink main body, e.g. the heat-conducting plate or plates.

### List of reference signs

- 10: apparatus
- 12: inlet
- 14: outlet
- 16: internal cavity
- 18, 18a, 18b: heat-conducting plate
- 20: heat-conducting objects
- 21: ramp portion
- 20a, 20b, 20c: layers of heat-conducting objects
- 20d, 20e, 20f: layers of heat-conducting objects
- 22: supporting bar
- 24: supporting recess
- 25: receiving recess
- 26: supporting pin
- 28: housing
- 30: fluid channel
- 100: electronic device
- 102, 102a, 102b: data processing unit
- 1000: vehicle
- F: flow of cooling liquid
- CL: cooling liquid

## Claims

1. An apparatus (10) for liquid cooling at least one data processing unit (102), comprising:
an inlet (12) for receiving a cooling liquid;
an outlet (14) for outputting the cooling liquid;
an internal cavity (16) arranged between the inlet (12) and the outlet (14) and fluidically connecting the inlet (12) and the outlet (14);
at least one heat-conducting plate (18) extending along a side of the internal cavity (16) and comprising a heat-conducting material and configured to be in thermal contact with the at least one data processing unit (102); and
a plurality of discrete heat-conducting objects (20) each comprising a heat-conducting material and arranged in the internal cavity (16) in a pattern;
wherein each of the plurality of heat-conducting objects (20) contacts at least another one of the plurality of heat-conducting objects (20) in the internal cavity (16);
wherein at least one of the plurality of heat-conducting objects (20) is in thermal contact with the at least one heat-conducting plate (18); and
wherein the plurality of heat-conducting objects (20) are arranged in the internal cavity (16) such that, when the apparatus (10) is in a liquid cooling operation, the cooling liquid at least partially surrounds the heat-conducting objects (20).

2. The apparatus (10) according to claim 1, wherein at least a part of the plurality of heat-conducting objects (20) is arranged in at least one layer or lattice pattern.

3. The apparatus (10) according to any one of the preceding claims, wherein at least a part of the heat-conducting objects (20) are convex objects.

4. The apparatus (10) according to claim 3, wherein the at least a part of the heat-conducting objects (20) are spheres and/or polygonal shaped elements.

5. The apparatus (10) according to claim 3 or 4, wherein the heat-conducting objects (20) have an average diameter in a range from about 1 mm to about 10 mm.

6. The apparatus (10) according to any one of the preceding claims, wherein the heat-conducting material of the plurality of heat-conducting objects (20) comprises at least one of copper, aluminium, silver, boron arsenide, a heat-conducting polymer or any combination thereof.

7. The apparatus (10) according to any one of the preceding claims, wherein the plurality of heat-conducting objects (20) are arranged in multiple layers (20a, 20b, 20c), wherein at least one of the layers (20a) is in thermal contact with the at least one heat-conducting plate (18) and the at least one of the layers (20a) being in thermal contact with the at least one heat-conducting plate (18) contacts another layer (20b) of the multiple layers (20a, 20b, 20c).

8. The apparatus (10) according to any one of the preceding claims, wherein at least some of the heat-conducting objects of the plurality of heat-conducting objects (20) have two, three, four, five, six, eight or twelve nearest-neighbouring heat-conducting objects or a combination thereof.

9. The apparatus (10) according to any one of the preceding claims, wherein the at least one heat-conducting plate (18) comprises two heat-conducting plates (18a, 18b), wherein the two heat-conducting plates (18a, 18b) are arranged opposite to each other with respect to the internal cavity (16) and each of the two heat-conducting plates (18a, 18b) is configured to be in thermal contact with at least one respective data processing unit (102).

10. The apparatus (10) according to any one of the preceding claims, wherein the apparatus (10) further comprises at least one supporting bar (22) arranged at the inlet (12) and/or the outlet (14) to prevent at least some of the heat-conducting objects of the plurality of heat-conducting objects (20) from misaligning in the internal cavity (16) and/or from moving out of the internal cavity (16).

11. The apparatus (10) according to any one of the preceding claims, wherein the apparatus (10) further comprises at least one supporting recess (24) configured to receive at least one of the heat-conducting objects of the plurality of heat-conducting objects (20), the at least one supporting recess (24) being arranged inside the internal cavity (16); and/or
wherein the apparatus (10) further comprises at least one supporting pin (26) arranged inside the internal cavity (16) and configured for aligning at least one heat-conducting object of the plurality of heat-conducting objects (20) and to prevent at least some of the plurality of heat-conducting objects (20) from moving out of the internal cavity (16).

12. An electronic device (100), comprising:
at least one data processing unit (102); and
an apparatus (10) according to any one of the preceding claims;
wherein the at least one data processing unit (102) is in thermal contact with the at least one heat-conducting plate (18).

13. The electronic device (100) according to claim 12, wherein the at least one data processing unit (102) comprises a first data processing unit (102a) and a second data processing unit (102b), and the at least one heat-conducting plate (18) comprises a first heat-conducting plate (18a) and a second heat-conducting plate (18b);
wherein the first data processing unit (102a) is in thermal contact with the first heat-conducting plate (18a) and the second data processing unit (102b) is in thermal contact with the second heat-conducting plate (18b);
wherein the first and second heat-conducting plates (18a, 18b) are arranged opposite to each other with respect to the internal cavity (16).

14. The electronic device (100) according to claim 12 or 13, wherein the electronic device (100) is part of, comprises or is an electronic control unit of a vehicle.

15. Vehicle (1000), comprising:
an electronic device (100) according to any one of the claims 12 to 14.
